(19) 

Europäisches
Patentamt
European
Patent Office
Office européen
des brevets

(11) **EP 3 832 317 A1**

(12) **EUROPEAN PATENT APPLICATION**

(43) Date of publication:
**09.06.2021 Bulletin 2021/23**

(21) Application number: **19275138.6**

(22) Date of filing: **03.12.2019**

(51) Int Cl.:
*G01P 3/48* (2006.01)          *G01D 5/20* (2006.01)
*G01D 5/14* (2006.01)          *G01P 3/488* (2006.01)
*G01P 3/489* (2006.01)          *H03H 11/04* (2006.01)
*H03H 11/12* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
**KH MA MD TN**

(71) Applicant: **Hamilton Sundstrand Corporation
Charlotte, NC 28217 (US)**

(72) Inventor: **DINU, Andrei
Leicester, Leicestershire LE3 3TJ (GB)**

(74) Representative: **Dehns
St. Bride's House
10 Salisbury Square
London EC4Y 8JD (GB)**

(54) **ADAPTIVE FILTER FOR MOTOR SPEED MEASUREMENT SYSTEM**

(57)     A filter for motor speed measurement signals, comprising one or more resonators configured to filter signals having a frequency that is proportional by a predetermined factor to the frequency of the motor whose speed is measured. In particular, the filter can be an adaptive notch filter which is tuned to the rotational speed of a motor, or to a harmonic of this speed. In this way, speed ripple caused by geometric imperfections, DC offsets, amplitude imbalances or quadrature errors may be eliminated.

*FIG. 1*

EP 3 832 317 A1

**Description**

TECHNICAL FIELD

The present disclosure is concerned with motor drive systems and with accurately determining the speed of a motor driven by such a system.

BACKGROUND

A drive system is typically commanded either to drive the motor to rotate at a given speed or to rotate to a given position. Typical motor drive applications use resolvers or Hall sensors to measure both motor speed and position which are fed back to control the drive system.

It is important to measure the motor speed and position accurately as the accuracy of measurement impacts directly on the dynamic performance of the drive. With known resolvers and Hall sensors, the actual motor speed/position information is derived by demodulating the sensor feedback signals.

Resolvers are extremely accurate, rugged, absolute transducers of position. They are based on fundamental transformer principles, with one primary winding plus two secondary windings, which are oriented in quadrature (90°) with respect to each other. The effective turns ratio and polarity between the primary and secondary windings varies depending on the angle of the shaft. The primary winding is excited with a reference AC waveform at constant amplitude and frequency, (typically around 10kHz) and the outputs of the secondary windings will have the same frequency but variable amplitude as a function of rotor position. The peak voltages of the secondary windings will vary as the shaft rotates, and will follow the profile of trigonometric functions Sin and Cos. By demodulating these outputs using the primary excitation signal as a reference, the resolver circuitry can provide a high-resolution readout of the shaft angle and, thus, motor speed/position.

Resolvers are rugged and are useful in challenging environments such as aircraft applications.

However, resolvers tend to be large and relatively costly compared to alternatives, and require a relatively large amount of power, which is often unacceptable in low-power applications. They also require relatively complex circuitry for generation and demodulation of the AC waveforms.

A smaller, lighter electronic device used for position sensing is a Hall sensor. Hall-effect devices can be used to sense the presence or absence of a nearby magnetic field. They produce voltage across an electrical semiconductor, at right angles to an electric current in the conductor and a magnetic field perpendicular to the current.

Similar to resolvers, Hall sensor encoders generate two feedback signals - sin and cos - indicative of the angle of the rotor and thus indicative of the motor speed. However, Hall sensors generate simple sin and cos signals. Resolvers use the sin and cos signals to modulate an excitation signal. In both cases, though, the signals are filtered and amplified and distortions occur. Such distortions include DC offsets and amplitude imbalances between the sin and cos signals caused by the analogue signal conditioning circuits that separate the sensor from the digital control system. Further, with Hall sensors, the accuracy can be affected by how the sensors are mounted and by their mechanical and electrical tolerances. This can lead to the sin and cos signals not having exactly a 90 deg. phase shift - so-called 'quadrature errors'.

Any distortions in the feedback signals will propagate through the demodulation algorithm and cause ripple in the measured motor speed.

There is a need to improve the accuracy of motor position and speed measurement.

SUMMARY

It is known that the measured speed ripple includes harmonics with frequency and amplitude which are proportional to the motor speed. DC offsets give rise to a speed ripple with frequency equal to the motor mechanical frequency. Amplitude imbalances and quadrature errors give rise to a ripple frequency that is twice the motor mechanical frequency. If more than one distortion type is present, the measured speed ripple will be the resulting sum of all the ripples.

The inventor has made use of the fact that the ripple is predictable based on the motor speed to create a filter to remove such ripple. In other words, an adaptive filter can be designed to remove ripple, without removing other useful information, from the speed measurement based on knowledge of the characteristics of the ripple. In this way, the filter is arranged to post-process the output provided from the algorithm that demodulates the sensor signals. This solution is able to filter out speed measurement ripple that will be encountered in most practical situations.

According to one aspect, there is provided a filter for motor speed measurement signals, comprising one or more resonators configured to filter signals having a frequency that is proportional by a predetermined factor to the frequency of the motor whose speed is measured. The one or more resonators is/are configured to have a resonant frequency proportional to the frequency of the motor. Each resonator is configured as a closed loop system comprising two variable-gain integrators connected in anti-parallel.

In one possible configuration, the filter has one resonator configured to filter signals having a frequency equal to the frequency of the motor.

In another possible configuration, the filter comprises one resonator configured to filter signals having a frequency equal to two times the frequency of the motor.

According to a second aspect, there is provided a speed position measuring system comprising a sensor arranged to determine the speed of rotation of a motor and to provide a speed measurement signal and a filter as described above arranged to receive the speed measurement signal and to filter ripple signals therefrom being signals having a frequency that is proportional by a predetermined factor to the frequency of the motor.

Preferably, the sensor comprises a resolver or a Hall Effect sensor.

The system may also comprise a demodulator to demodulate the output of the sensor to provide the speed measurement signal.

A motor drive system is also provided comprising motor drive circuitry to control a motor to rotate at a given speed, and a speed position measuring system as described above in a feedback loop between the sensor and the motor drive circuitry.

BRIEF DESCRIPTION OF THE DRAWINGS

Figure 1 is a simple representation of a single notch filter configuration in accordance with an embodiment of this disclosure.

Figure 2 is a simple representation of a double notch filter configuration in accordance with an embodiment of this disclosure.

Figure 3 is a simple representation of the configuration of a resonator such as shown in Figure 1 or 2.

Figure 4 shows the poles and zeroes as well as the frequency response of a single-notch filter.

Figure 5 shows a more detailed diagram of a single-notch filter.

DETAILED DESCRIPTION

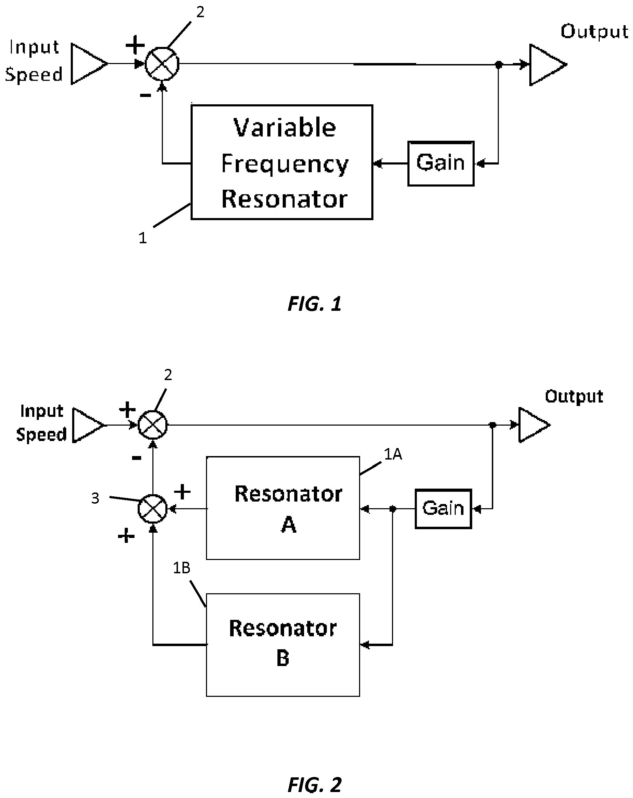

Fig. 1 shows a filter configuration according to an embodiment of the present disclosure. The filter is configured to filter out ripple from a speed signal derived from a motor speed sensor (not shown) such as (as discussed above) a resolver or a Hall sensor. The measured speed signal will include ripple due to feedback distortions caused by the speed sensors and other analogue interface components.

The speed signal from the demodulation algorithm is usually provided as feedback to the speed control loop of the motor drive system (not shown).

The filter in the embodiment of Fig. 1, a so-called 'single-notch' filter includes a variable frequency resonator 1 provided on a feedback path. The resonator 1 is configured, based on the average measured motor speed, knowing how the ripple is related to that speed, to remove the ripple from the input signal applied to subtracter 2.

If two different ripple frequencies are to be removed, the filter can be designed as a double-notch filter as shown in Fig. 2 comprising two resonators ($1_A$ and $1_B$) and two adders/subtracters 2,3.

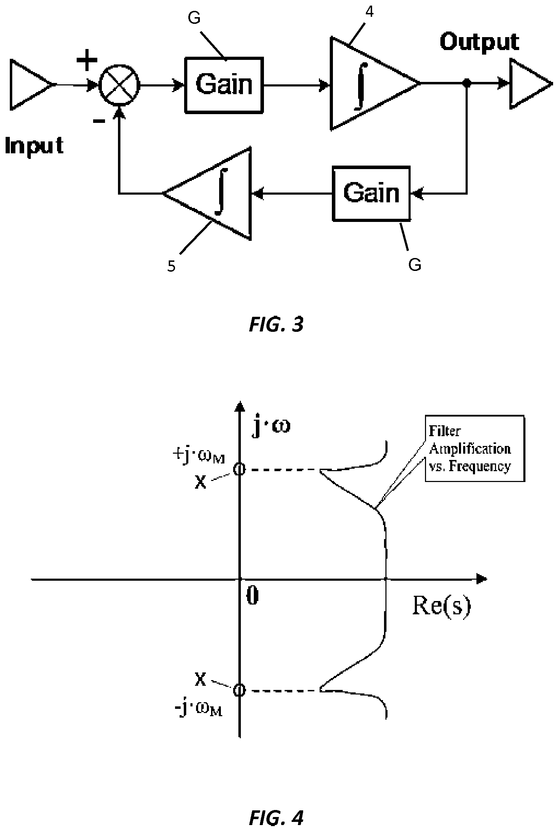

The resonator(s) has/have a structure as shown in Fig. 3. As shown, each resonator is a closed loop system comprising two variable-gain integrators 4,5 connected in anti-parallel.

As mentioned above, the ripple frequency is known to be proportional to the mechanical frequency of the motor by a factor dependent on the type of distortion as discussed above - for DC offsets, the ripple frequency is equal to the motor frequency; for other distortions it is double the motor frequency.

For a single notch filter as shown in Fig. 1, the gain of the resonator should be such that the resonant frequency of the resonator is the same as the motor mechanical frequency as that will be the frequency of the ripple to be removed from the speed signal (for the first type of distortion mentioned above).

The resonator 1 of Fig. 1 has a configuration as shown in Fig. 3. If both integrators 4,5 have the same gain $G = \omega_M = 2\pi \cdot f_M$ (where $f_M$ is the motor mechanical frequency) then the transfer function of the resonator is as follows:

$$H_{OSC}(s) = \frac{\dfrac{\omega_M}{s}}{1 + \dfrac{\omega_M}{s} \cdot \dfrac{\omega_M}{s}} = \frac{\omega_M \cdot s}{s^2 + \omega_M^2}$$

Thus, the resonant frequency is equal to the motor mechanical frequency, which covers the first type of signal distortion mentioned above. The closed loop filter transfer function is the following (where $K_3$ is the filter gain in Figure 1):

$$H_{NF}(s) = \frac{1}{1 + K_3 \cdot \dfrac{\omega_M \cdot s}{s^2 + \omega_M^2}} = \frac{s^2 + \omega_M^2}{s^2 + \omega_M^2 + K_3 \omega_M \cdot s}$$

Gain $K_3$ needs to be tuned such that the positions of the two filter poles are close to the positions of the filter zeroes in order to achieve very narrow frequency notches (see Figure 4). The real components of the poles need to be small negative values. The imaginary components of the poles need to be in approximate alignment to the imaginary components of the zeroes (see again Figure 4). The filter poles are:

$$P_{1,2} = \frac{-K_3 \omega_M \pm \omega_M \sqrt{K_3^2 - 4}}{2}$$

The condition for the filter stability is $K_3 < 2$. Very small $K_3$ produces very good vertical alignment between poles and zeroes. However, this also reduces the stability margin of the filter by bringing the poles very close to the imaginary axis. Larger $K_3$ improves the filter stability but also increases the width of the frequency notches.
A good compromise is produced by $K_3 = 0.25$. The resulting poles are:

$$P_{1,2} = -0.125 \cdot \omega_M \pm 0.99 \cdot j\omega_M$$

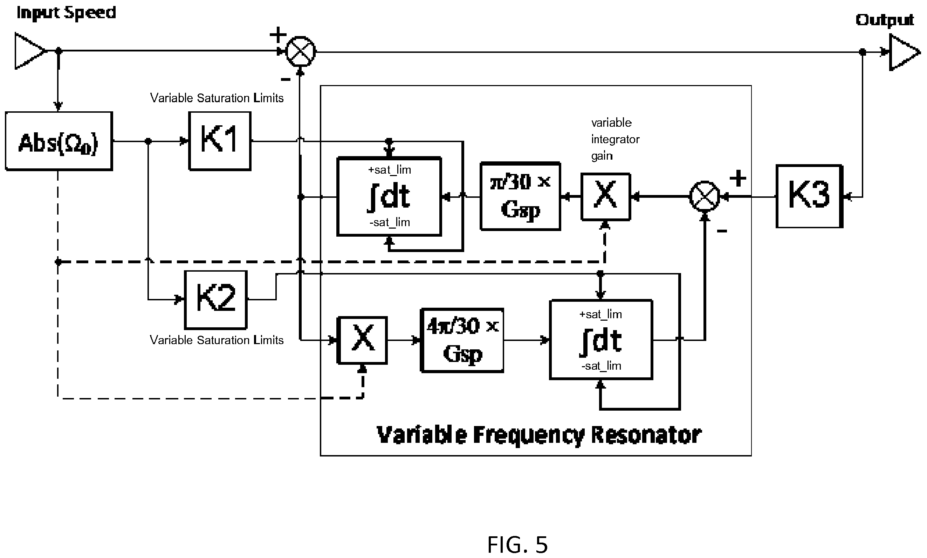

The amplitude of the speed oscillations caused by the Sin and Cos distortions is proportional to the motor speed. Therefore, almost no oscillations are present in the measured speed when the motor speed if very low. However the resonator inside the filter will always oscillate after any fast transient on the input signal. For instance, this can happen when the motor speed decreases rapidly from high speed to low speed.
The full filter configuration needs to include variable saturation limits for the two integrators to eliminate unwanted oscillations in the resonator. The integrator limits will be proportional to the absolute value of the motor speed as indicated in Figure 5. The proportionality factors $K_1$ and $K_2$ are set based on the following considerations:

- Gain $K_1$ needs to be set just above the amplitude of the oscillations in the input speed measurement in order to allow these oscillations to be removed by the negative feedback loop of the filter.

- The steady state value of the second integrator is "Input Speed x $K_3$".

Therefore gain $K_1$ needs to be set slightly larger than $K_2$ to provide margin for the oscillations that occur when speed ripple is being eliminated by the filter.
The recommended value is:

$$K_1 = 1.25 K_2 = 0.3125$$

A second resonator can be added to the filter if two frequencies need to be removed from the input signal (see Figure 2). The integrator gains of the second resonator are set to $G = 2 \cdot \omega_M$.

The filter of this disclosure provides improved motor speed measurement accuracy when the position sensor outputs are affected by sensor distortions. The filter is also immune to variations in analogue component parameters of the drive system.

The described embodiments are by way of example only. The scope of this disclosure is limited only by the claims.

**Claims**

1. A filter for motor speed measurement signals, comprising one or more resonators (1) configured to filter signals having a frequency that is proportional by a predetermined factor to the frequency of the motor whose speed is measured.

2. The filter of claim 1, wherein the one or more resonators (1) is/are configured to have a resonant frequency proportional to the frequency of the motor.

3. The filter of claim 1 or 2, wherein each resonator (1) is configured as a closed loop system comprising two variable-gain integrators connected in anti-parallel.

4. The filter of any preceding claim, comprising one resonator (1) configured to filter signals having a frequency equal to the frequency of the motor.

5. The filter of any preceding claim, comprising one resonator configured to filter signals having a frequency equal to two times the frequency of the motor.

6. A speed position measuring system comprising a sensor arranged to determine the speed of rotation of a motor and to provide a speed measurement signal and a filter according to any of claims 1 to 5 arranged to receive the speed measurement signal and to filter ripple signals therefrom being signals having a frequency that is proportional by a predetermined factor to the frequency of the motor.

7. The speed position measuring system of claim 6, wherein the sensor comprises a resolver.

8. The speed position measuring system of claim 6, wherein the sensor comprises a Hall effect sensor.

9. The speed position measuring system of any of claims 6 to 8, further comprising a demodulator to demodulate the output of the sensor to provide the speed measurement signal.

10. A motor drive system comprising motor drive circuitry to control a motor to rotate at a given speed, and a speed position measuring system as claimed in any of claims 6 to 9 in a feedback loop between the sensor and the motor drive circuitry.

11. The system of claim 10, further comprising the motor.

**FIG. 1**

**FIG. 2**

*FIG. 3*

*FIG. 4*

FIG. 5

Europäisches
Patentamt

European
Patent Office

Office européen
des brevets

# EUROPEAN SEARCH REPORT

**Application Number**

EP 19 27 5138

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2004/066162 A1 (CARLSON DANIEL H [US]) 8 April 2004 (2004-04-08) * paragraphs [0002] - [0018], [0041] - [0052], [0064] - [0066], [0097], [0103]; claims 1-7; figure 1 * | 1-11 | INV.<br>G01P3/48<br>G01D5/20<br>G01D5/14<br>G01P3/488<br>G01P3/489 |
| Y | US 2011/051782 A1 (GUPTA DIVI [US] ET AL) 3 March 2011 (2011-03-03) * paragraphs [0008], [0009], [0060], [0081] - [0083]; figures 10 A, 10 B * | 1-11 | H03H11/04<br>H03H11/12 |
| Y | US 3 987 370 A (SCHUTZ ALAN E) 19 October 1976 (1976-10-19) * column 3, line 29 - column 3, line 35; figures 4A, 4B * * column 5, line 26 - column 6, line 51 * * column 7, line 19 - column 7, line 50 * | 1-11 | |
| Y | JP H03 169283 A (YOKOGAWA ELECTRIC CORP) 22 July 1991 (1991-07-22) * the whole document * | 1-11 | |

**TECHNICAL FIELDS SEARCHED (IPC)**

G01P
G01D
H03H

The present search report has been drawn up for all claims

| Place of search | Date of completion of the search | Examiner |
|---|---|---|
| Munich | 29 May 2020 | Felicetti, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    .....................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 27 5138

This annex lists the patent family members relating to the patent documents cited in the above-mentioned European search report.
The members are as contained in the European Patent Office EDP file on
The European Patent Office is in no way liable for these particulars which are merely given for the purpose of information.

29-05-2020

| Patent document cited in search report | | Publication date | Patent family member(s) | | | Publication date |
|---|---|---|---|---|---|---|
| US 2004066162 | A1 | 08-04-2004 | AT | 350670 | T | 15-01-2007 |
| | | | AU | 2003268038 | A1 | 19-04-2004 |
| | | | BR | 0314317 | A | 26-07-2005 |
| | | | DE | 60310980 | T2 | 11-10-2007 |
| | | | EP | 1556706 | A2 | 27-07-2005 |
| | | | JP | 2006500683 | A | 05-01-2006 |
| | | | KR | 20050065555 | A | 29-06-2005 |
| | | | MX | PA05002567 | A | 27-05-2005 |
| | | | US | 2004066162 | A1 | 08-04-2004 |
| | | | WO | 2004029634 | A2 | 08-04-2004 |
| US 2011051782 | A1 | 03-03-2011 | CN | 101971508 | A | 09-02-2011 |
| | | | EP | 2253066 | A2 | 24-11-2010 |
| | | | JP | 5528358 | B2 | 25-06-2014 |
| | | | JP | 2011526428 | A | 06-10-2011 |
| | | | KR | 20100126484 | A | 01-12-2010 |
| | | | US | 2011051782 | A1 | 03-03-2011 |
| | | | WO | 2009114123 | A2 | 17-09-2009 |
| US 3987370 | A | 19-10-1976 | NONE | | | |
| JP H03169283 | A | 22-07-1991 | JP | 2576644 | B2 | 29-01-1997 |
| | | | JP | H03169283 | A | 22-07-1991 |

EPO FORM P0459

For more details about this annex : see Official Journal of the European Patent Office, No. 12/82